# EUROPEAN PATENT SPECIFICATION

(11) **EP 2 829 155 B1**
(45) Date of publication and mention of the grant of the patent: **07.09.2022**
(21) Application number: 13764286.4
(22) Date of filing: 20.03.2013
(51) Int. Cl.: H05B 3/20, H05B 3/24, H05B 3/14, H01L 21/67

(54) **RESISTANCE HEATER**
WIDERSTANDSHEIZER
ÉLÉMENT DE CHAUFFAGE PAR RÉSISTANCE

(30) Priority: 20.03.2012 US 201213424947
(43) Date of publication of application: 28.01.2015
(73) Proprietor: Momentive Performance Materials Quartz, Inc., Strongsville, OH 44149 (US)
(72) Inventor: MORIKAWA, Yuji, Himeji-Shi Hyogo 671-1213 (JP); MATSUI, Yoshihiko, Himeji-Shi Hyogo 671-1241 (JP); OTAKA, Akinobu, Kobe Hyogo 657-0861 (JP); HIGUCHI, Takeshi, Kobe Hyogo 650-0047 (JP); FUJIMURA, Kensuke, Tochigi 329-3222 (JP); LU, Zhong-Hao, Twinsburg, OH 44087 (US)
(74) Representative: Müller-Boré & Partner Patentanwälte PartG mbB
(86) International application number: PCT/US2013/033139
(87) International publication number: WO 2013/142594

(56) References cited:
- US-A- 4 147 888
- US-A1- 2005 217 799
- US-A1- 2009 200 288
- US-A1- 2010 000 292
- US-B1- 6 285 011

## Description

### CROSS-REFERENCE TO RELATED APPLICATIONS

This application claims the benefit of U.S. Patent Application No.: 13/424,947 entitled "Resistance Heater" filed on March 20, 2012, which is a continuation-in-part of U.S. Patent Application No. 12/321,284 filed on January 26, 2009.

### BACKGROUND

The present invention relates to a resistance heater made from a material such as graphite, SiC, etc., and more particularly to a heater to be used for directly or indirectly heating a semiconductor wafer in a semiconductor wafer processing device in which , for example, CVD (chemical vapor deposition) or other coating method is carried out.

An example of the prior art heaters is disclosed in Japanese patent publication No. 2005-86117(A). This heater uses an elongated ceramic body of a rectangular cross-section having greater width than thickness, which is formed into a ring or spiral configuration. This heater has low electric resistance, so that it will be required to use a power source that operates with low voltage and high current, resulting in increase of costs for the power source. In addition, this heater will tend to be bent, warped or deformed especially when it is subjected to a high temperature condition. This makes it impossible to uniformly heat a wafer or any other object to be processed at high temperature. US 2009/200288 A1 (MORIKAWA ET AL) 13 August 2009 (2009-08-13) describes a resistance heater for processing a semiconductor wafer.

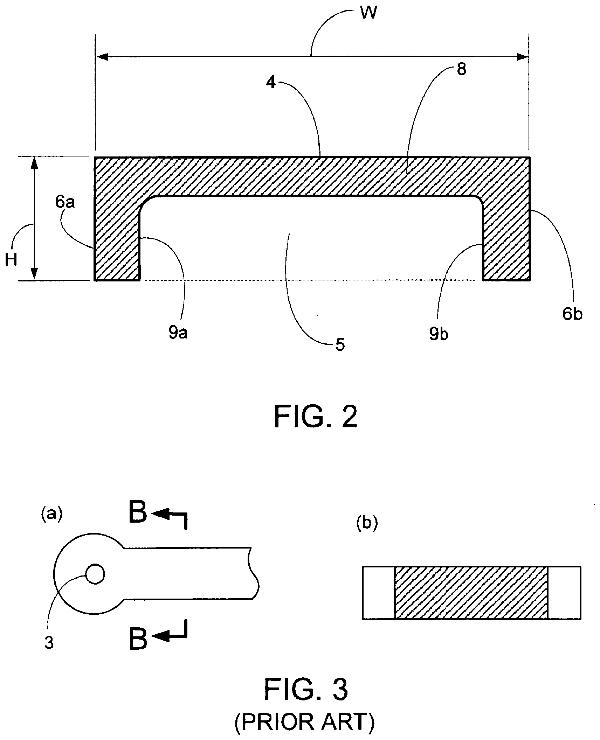

A typical shape of the prior art heater is shown in FIG. 3 herein, which includes an expanded view of terminal end portion with a connecting hole. The reason the terminal end portions have a widened and expanded shape at the end portion is that there needs to be decreased electric resistance at that portion so as to prevent that portion from over-heating. However, when using this heater, the expanded terminal end portion could make designing a heat pattern more difficult. A simple heat pattern could not be achieved with the prior art heater having the expanded terminal end portions.

### SUMMARY

Accordingly, the present invention provides a heater as defined in claim 1, having higher electric resistance and improved strength to prevent deformation of the heater even in a high temperature condition. The present invention also prevents excessive heat generation at terminal end portions of a heater, while the terminal end portion remains narrow and not expanded, thereby providing a wider choice in heat pattern design.

A resistance heater may include a body. The body of the resistance heater may include at least one heating surface, the heating surface being generally smooth and generally flat, a recess formed in the body, at least a portion of the body having a cross-sectional shape selected from the group consisting of: generally U shape, generally I-shape, and generally H-shape, and where the cross-sectional shape extends along at least a portion of the body.

A method for processing a semiconductor wafer may include the steps of providing a resistance heater having a body having at least one heating surface, the heating surface being generally smooth and generally flat; a recess formed in the body, at least a portion of the body having a generally horizontally symmetrical cross-sectional shape; and where the cross-sectional shape extends along at least a portion of the body. The method may further include supporting a semiconductor wafer on the at least one heating surface, applying an electric current to the heater, and heating the semiconductor wafer to a predetermined temperature.

A resistance heater may include a body. The body may include at least one heating surface, the heating surface being generally smooth and generally flat. The body may also include a recess formed in the body, at least a portion of the body having a generally horizontally symmetrical cross-sectional shape, and where the cross-sectional shape extends along at least a portion of the body.

### BRIEF DESCRIPTION OF DRAWINGS

Other objects and advantages of the present invention can be understood from the following description when read in conjunction with the accompanying drawings in which:
FIG. 1 is a plan view of a resistance heater embodying the present invention,
FIG. 2 is an enlarged cross-section taken along A-A in FIG. 1;
FIG. 3 shows a conventional heater, in which z is a partial plan view thereof and FIG. 3(b) is an enlarged cross-section taken along B-B in FIG. 3(a);
FIG. 4 is a plan view of a resistance heater embodying a spiral shape;
FIG. 5 is a plan view of a resistance heater embodying a rectangular shape;
FIG. 6. is a plan view of other embodiments of a resistance heater;
FIG. 7 is an enlarged cross-sectional view of the resistance heater of FIG. 6 taken along line 7-7.
FIG. 8 is a plan view of other embodiments of a resistance heater; and
FIG. 9 is an enlarged cross-sectional view of the resistance heater of FIG. 8 taken along line 9-9.

### DETAILED DESCRIPTION

Reference will now be made in detail to exemplary embodiments of the present invention, examples of which are illustrated in the accompanying drawings.

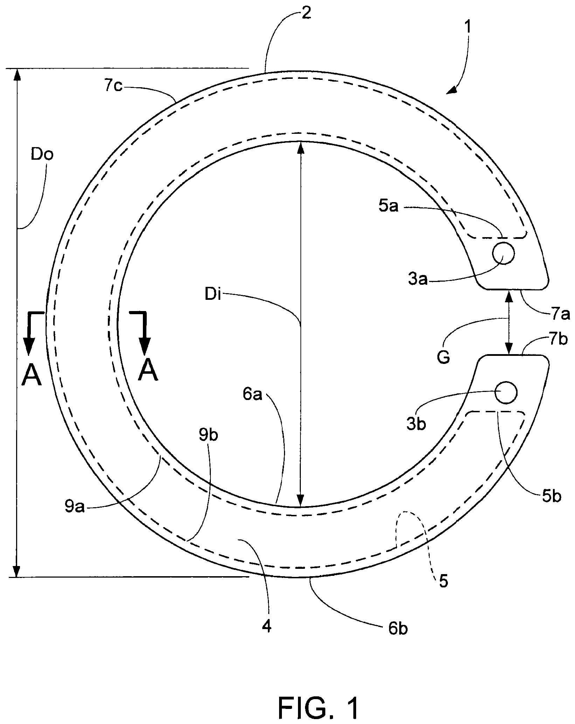

A heater embodying the present invention is shown in Figs. 1 and 2. Heater 1 comprises a C-shaped heater body 2 made from a material such as graphite, ceramics such as SiC, etc. There are terminal connecting holes 3a, 3b at respective end portions of the C-shaped heater body 2, the opposing exterior end surfaces 7a and 7b being spaced apart so as to define a gap G therebetween. The connecting holes 3a and 3b are the points of attachment of an electrical power source which provides the electric current to the heater 1. By way of example, in this embodiment the heater body 2 can have a cross-section width W of about 20 mm, a height H of about 6 mm, an inner diameter Di of about 100 mm and an outer diameter Do of about 140 mm. These dimensions are exemplary of a suitable size. Other dimensions can be selected when appropriate.

As clearly shown in FIG. 2, which is an enlarged cross-section taken along A-A in FIG. 1, the heater body 2 has an upper horizontal wall 8 having a smooth and flat top heating surface 4 onto which an object to be heated, such as a wafer, is mounted directly or indirectly via a susceptor, etc. A center portion of the underside of the heater body 2 is recessed to form an elongated groove or recess 5 between a pair of opposite vertical side walls or ribs 6a, 6b, said side walls having inner surfaces 9a and 9b which at least partially define recess 5. The recess 5 and side walls 6a, 6b extend in an arcuate linear direction of the C-shaped heater body 2 so as to provide an inverted U-shaped cross section along a middle portion 7c of the heater, but not at the end portions of the heater body. In particular, the recess 5 terminates at end surfaces 5a and 5b, the portion of the body between recess end surfaces 5a and 5b and the respective exterior end surfaces 1a and 1b defining the respective end portions of the body. In one embodiment, the underside of the heater body having 20 mm width comprises the recess 5 having 16 mm width and the opposite side walls 6a, 6b, each having 2 mm width. The recess 5 is 4 mm deep from the underside of the heater body 2, leaving the upper horizontal wall 8 of 2 mm thickness.

As indicated above, it is a feature of the invention that body 2 has the same width W along its entire length, including both end portions and the middle portion 7c therebetween.

The heater of the present invention is particularly advantageous in semiconductor wafer processing applications. The full thickness of the body 2 at the end portions maintains a relatively cooler temperature at the end portions but the uniform width of the body improves control of the heat distribution pattern. The middle portion 7c of the body has a reduced cross sectional area available for electrical conduction thereby increasing, and improving heater resistance.

### EXAMPLE

A heater was fabricated in accordance with this invention having a width of 20 mm and a height of 6 mm, and which exhibited a resistance 0.09 Ω. In comparison, a control heater made of the same type material and having a width of 20 mm width and height of 6 mm, but fabricated without a recess 5 and ribs 6a, 6b, exhibited a resistance of 0.04 Ω. These test results show that the heater resistance is dramatically improved by forming the recess 5 on the underside of the heater body 2.

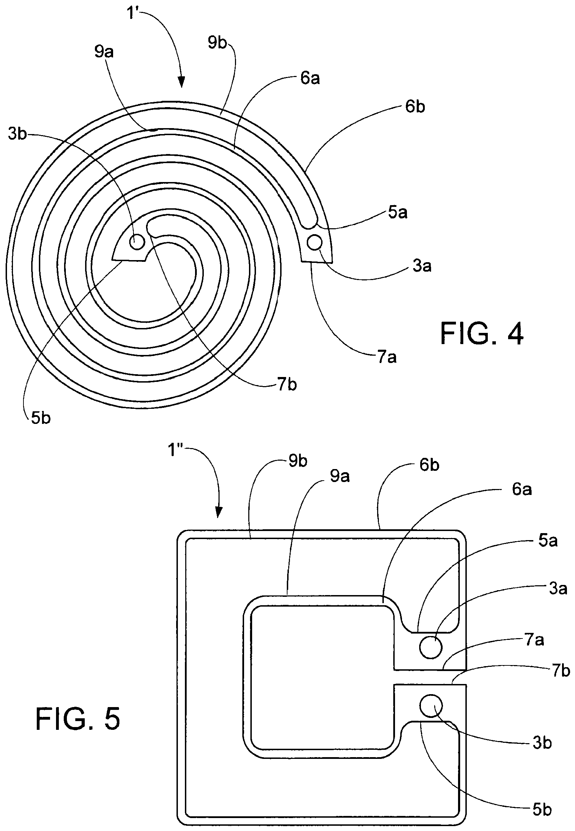

Although the present invention has been described in reference to specific embodiment thereof shown in the accompanying drawings, it should be understood that the present invention is not limited to this specific embodiment and involves various modifications and changes without departing as far as they are within the spirit and scope of the invention defined in the appended claims. For example, the heater body is C-shaped in the illustrated embodiment, but in many cases, the heater body can be designed into a spiral heat pattern, such as heater 1' shown in Fig. 4, and as shown in Japanese patent publication No. 2005-86117(A), for uniform heating to the wafer or any other object to be heated. In some applications, the heater body is formed into a square or rectangular pattern, such as heater 1" shown in Fig. 5. These and other heater shapes are also within the scope of the present invention.

Additional embodiments of a resistance heater according the present teachings are described below. In the descriptions, all of the details and components may not be fully described or shown. Rather, the features or components are described and, in some instances, differences with the above-described embodiments may be pointed out. Moreover, it should be appreciated that these additional embodiments may include elements or components utilized in the above-described embodiments although not shown or described. Thus, the descriptions of these additional embodiments are merely exemplary and not all-inclusive nor exclusive. Moreover, it should be appreciated that the features, components, elements and functionalities of the various embodiments may be combined or altered to achieve a desired resistance heater without departing from the spirit and scope of the present teachings.

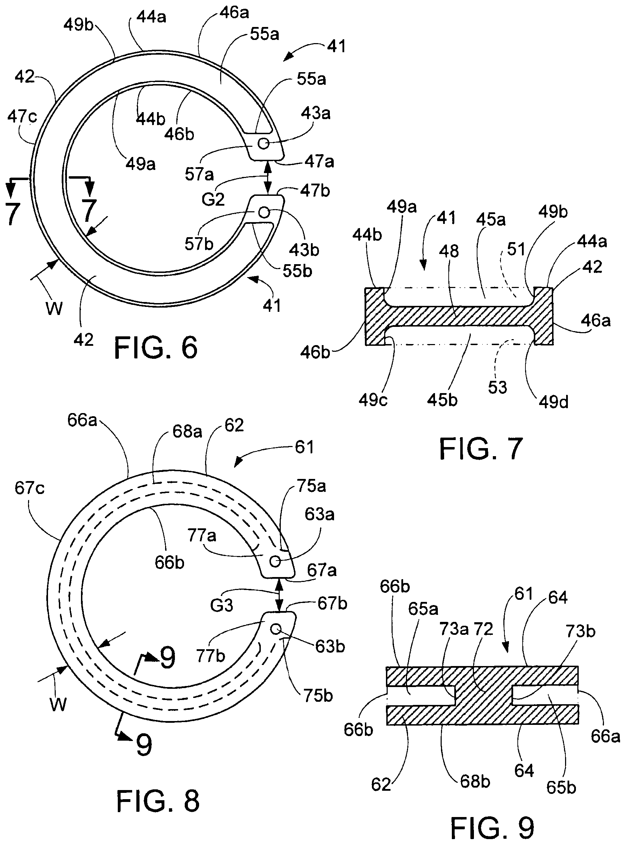

Embodiments of a resistance heater are shown in FIGS. 6 and 7. Resistance heater 41 may include a generally a C-shaped heater body 42. The heater body 42 may be made from any appropriate material, such as by way of a non-limiting example, graphite, ceramics such as SiC, etc. The heater body 42 may include terminal connecting holes 43a, 43b, which may be located at respective end portions of the C-shaped heater body 42. The opposing exterior end surfaces 47a and 47b may be generally spaced apart so as to define a gap G2 between such. The connecting holes 43a and 43b may be the points of attachment of an electrical power source (not shown) that may provide the electric current to the resistance heater 41. By way of a non-limiting example, in these embodiments the heater body 42 may have a cross-sectional shape such as shown in FIG. 7.

As shown in FIG. 7 the heater body 42 may have a generally horizontally symmetrical cross-sectional shape, such as by way of a non-limiting example, a generally H-shaped cross-sectional shape. In these embodiments, the heater body 42 may include a generally centrally positioned and generally horizontal wall 48.

In these embodiments, a top and bottom central portion 51, 53 of the heater body 42 may be recessed to form a pair of elongated grooves or recesses 45a, 45b between a pair of opposite vertical side walls or ribs 46a, 46b. The recesses 45a, 45b may be positioned on both the top and bottom portion of the heater body 42. The side walls 46a, 46b may each include inner surfaces 49a, 49b, 49c and 49d, which may at least partially define the recesses 45a, 45b. The recesses 45a, 45b and side walls 46a, 46b may extend in an arcuate linear direction of the generally C-shaped heater body 42. This may provide a generally H-shaped cross sectional shape along at least a middle portion 47c of the resistance heater 41. The vertical side walls 46a, 46b may each possess a generally smooth and flat heating surface 44a, 44b, respectively onto which an object to be heated, such as a wafer, may be mounted directly or indirectly via a susceptor, etc.

The general H-shaped cross-sectional shape, however, may not extend to the end portions 47a, 47b of the heater body 42. By way of a non-limiting example, the recesses 45a, 45b may generally terminate at end surfaces 55a and 55b, the portion of the body 42 between recess end surfaces 55a and 55b and the respective exterior end surfaces 47a and 47b may define the respective end portions 57a, 57b of the body 42. By way of a non-limiting example, the topside and underside of the heater body 42 may have a width W of approximately 20 mm, which may include the recesses 45a, 45b having a width of approximately 16 mm and the opposite side walls 46a, 46b each having a width of approximately 6 mm. The recesses 45a, 45b may be approximately 2 mm deep from the topside and underside of the heater body 42, leaving the central horizontal wall 48 of a thickness of approximately 2 mm.

As indicated above, the body 42 may have width W along its entire length, including both end portions and the middle portion 47c therebetween. The width W may be generally consistent along an entire length of the body 42. In some embodiments, the width W may be approximately 20 mm. While the exemplary dimensions are described above, the present teachings are not limited to these specific dimensions. The dimensions are merely exemplary and may be altered as required.

Embodiments of a heater are shown in FIGS. 8 and 9. Resistance heater 61 may include a generally a C-shaped heater body 62. The heater body 62 may be made from any appropriate material, such as by way of a non-limiting example, graphite, ceramics such as SiC, etc. The heater body 62 may include terminal connecting holes 63a, 63b, which may be located at respective end portions of the C-shaped heater body 62. The opposing exterior end surfaces 67a and 67b may be generally spaced apart so as to define a gap G3 between such. The connecting holes 63a and 63b may be the points of attachment of an electrical power source (not shown) that may provide the electric current to the resistance heater 61. By way of a non-limiting example, in these embodiments the heater body 62 may have a cross-sectional shape such as shown in FIG. 9.

As shown in FIG. 9 the heater body 62 may have a generally symmetrical cross-sectional shape, such as by way of a non-limiting example, a generally I-shaped cross-sectional shape. Still further, the heater body 62 may have a generally horizontally symmetrical cross-sectional shape. In these embodiments, the heater body 62 may include a pair of generally horizontal walls 68a and 68b. The first wall 68a may be on the top portion of the body 62 and the second wall 68b may be on the bottom portion of the body 62. Either or both of the horizontal walls 68a and 68b may possess a generally smooth and flat heating surface 64 onto which an object to be heated, such as a wafer, may be mounted directly or indirectly via a susceptor, etc.

In these embodiments, a pair of side walls 66a, 66b of the heater body 62 may be recessed to form a pair of elongated grooves or recesses 65a, 65b. By way of a non-limiting example, the recesses 65a, 65b may be formed in the pair of opposite vertical side walls 66a, 66b in any appropriate manner. Once the recesses 65a, 65b may be formed in the vertical side walls 66a, 66b, a generally central wall 72 may be formed in the heater body 62. This may define the generally I-shaped cross-sectional heater body 42. Side walls 73a, 73b of the central wall 72 may define the recesses 65a, 65b.

The recesses 65a, 65b and side walls 73a, 73b may extend in an arcuate linear direction of the generally C-shaped heater body 62 so as to provide a generally I-shaped cross sectional shape along at least a middle portion 67c of the resistance heater 61. The generally I-shaped cross-sectional shape, however, may not extend to the end portions 75a, 75b of the heater body 62. By way of a non-limiting example, the recess 65a, 65b may terminate at end surfaces 75a and 75b. The portion of the body 62 between recess end surfaces 75a and 75b and the respective exterior end surfaces 67a and 67b may define the respective end portions 77a, 77b of the body 62.

By way of a non-limiting example, the topside and underside of the heater body 62 may have a width of approximately 20 mm, which may include the recesses 65a, 65b having a height of approximately 2 mm a depth of approximately 7 mm from the vertical side walls 66a, 66b of the heater body 62. This may result in the thickness of walls 68a and 68b at the recesses 65a, 65b each being approximately 2 mm. The central wall 72 may have a width of approximately 6 mm and a thickness of approximately 6 mm.

As indicated above, the body 62 may have width W along its entire length, including both end portions 77a, 77b and the middle portion 67c therebetween. The width W may be generally consistent along an entire length of the body 62 and may be approximately 20 mm. While the exemplary dimensions are described above, the present teachings are not limited to these specific dimensions. The dimensions are merely exemplary and may be altered as required.

Although the embodiments of the present invention have been illustrated in the accompanying drawings and described in the foregoing detailed description, it is to be understood that the present invention is not to be limited to just the embodiments disclosed, but that the invention described herein is capable of numerous rearrangements, modifications and substitutions without departing from the scope of the claims hereafter. The claims as follows are intended to include all modifications and alterations insofar as they come within the scope of the claims.

## Claims

1. Use of a resistance heater (1) for processing a semiconductor wafer, the resistance heater (1) comprising:
a body (2) comprising:
at least one heating surface (4), the at least one heating surface (4) being generally smooth and generally flat;
a recess (5) formed in the body (2); and
first and second end portions (7a, 7b), wherein the recess (5) is not formed in the first and second end portions (7a, 7b),
**characterized in that** at least a portion of the body (2) has a horizontally symmetrical cross-sectional shape, wherein horizontally symmetrical means symmetrical with respect to a plane parallel to the at least one heating surface (4), and wherein the cross-sectional shape extends along at least a portion of the body (2), and
wherein the recess (5) is formed in portions of both first and second surfaces of the body (2) forming a generally I-shaped cross-sectional shape, or
wherein the recess (5) is formed in portions of both first and second surfaces of the body (2) forming a generally H-shaped cross-sectional shape.

2. Use according to claim 1, wherein the first and second end portions (7a, 7b) include a terminal connecting hole (3a, 3b).

3. Use according to claim 1, wherein the recess (5) is formed in portions of both first and second surfaces of the body (2) forming a generally I-shaped cross-sectional shape, and the first and second surfaces are top and bottom surfaces of the body (2), respectively.

4. Use according to claim 1, wherein the recess (5) is formed in portions of both first and second surfaces of the body (2) forming a generally H-shaped cross-sectional shape, and the first and second surfaces are opposite side surfaces of the body (2).

5. Use according to claim 1, wherein the first and second end portions (7a, 7b) have substantially identical width to a heating area defined between the first and second end portions (7a, 7b), and said recess (5) is not formed at the first and second end portions (7a, 7b).

6. Use according to claim 1, wherein the body (2) is coated with at least one of pBN and SiC.

7. Use according to claim 1, wherein the body (2) has a substantially uniform width along its length.

8. Use according to any one of claims 1 to 7, comprising the steps of:
(a) supporting a semiconductor wafer on the at least one heating surface (4) of the resistance heater (1);
(b) applying an electric current to the heater (1); and
(c) heating the semiconductor wafer to a predetermined temperature.

## Patentansprüche

1. Verwendung eines Widerstandsheizers (1) zum Bearbeiten eines Halbleiterwafers, wobei der Widerstandsheizer (1) umfasst:
einen Körper (2), umfassend:
mindestens eine Heizfläche (4), wobei die mindestens eine Heizfläche (4) im Allgemeinen glatt und im Allgemeinen flach ist;
eine in dem Körper (2) ausgebildete Aussparung (5); und
einen ersten und zweiten Endabschnitt (7a, 7b), wobei die Aussparung (5) nicht in dem ersten und zweiten Endabschnitt (7a, 7b) ausgebildet ist,
**dadurch gekennzeichnet, dass** mindestens ein Abschnitt des Körpers (2) eine horizontalsymmetrische Querschnittsform aufweist, wobei horizontalsymmetrisch symmetrisch in Bezug auf eine Ebene bedeutet, die parallel zu der mindestens einen Heizfläche (4) ist, und wobei der Querschnitt sich entlang mindestens eines Abschnitts des Körpers (2) erstreckt, und
wobei die Aussparung (5) in Abschnitten sowohl der ersten als auch der zweiten Oberfläche des Körpers (2) ausgebildet ist, eine allgemein I-förmige Querschnittsform bildend, oder
wobei die Aussparung (5) in Abschnitten sowohl der ersten als auch der zweiten Oberfläche des Körpers (2) ausgebildet ist, eine im Allgemeinen H-förmige Querschnittsform bildend.

2. Verwendung nach Anspruch 1, wobei der erste und der zweite Endabschnitt (7a, 7b) ein Anschlussverbindungsloch (3a, 3b) umfassen.

3. Verwendung nach Anspruch 1, wobei die Aussparung (5) in Abschnitten sowohl der ersten als auch der zweiten Oberfläche des Körpers (2) ausgebildet ist, eine im Allgemeinen I-förmige Querschnittsform bildend, und die erste und die zweite Oberfläche eine obere bzw. untere Oberfläche des Körpers (2) sind.

4. Verwendung nach Anspruch 1, wobei die Aussparung (5) in Abschnitten sowohl der ersten als auch der zweiten Oberfläche des Körpers (2) ausgebildet ist, eine im Allgemeinen H-förmige Querschnittsform bildend, und die erste und die zweite Oberfläche gegenüberliegende Seitenoberflächen des Körpers (2) sind.

5. Verwendung nach Anspruch 1, wobei der erste und zweite Endabschnitt (7a, 7b) eine im Wesentlichen identische Breite zu einem Heizbereich aufweisen, der zwischen dem ersten und zweiten Endabschnitt (7a, 7b) definiert ist, und die Aussparung (5) nicht an dem ersten und zweiten Endabschnitt (7a, 7b) ausgebildet ist.

6. Verwendung nach Anspruch 1, wobei der Körper (2) mit mindestens einem von pBN und/oder SiC beschichtet ist.

7. Verwendung nach Anspruch 1, wobei der Körper (2) entlang seiner Länge eine im Wesentlichen gleichmäßige Breite aufweist.

8. Verwendung nach einem der Ansprüche 1 bis 7, umfassend die Schritte:
(a) Stützen eines Halbleiterwafers auf der mindestens einen Heizfläche (4) des Widerstandsheizers (1);
(b) Anlegen eines elektrischen Stroms an die Heizeinrichtung (1); und
(c) Erwärmen des Halbleiterwafers auf eine vorbestimmte Temperatur.

## Revendications

1. Utilisation d'un fil résistant chauffant (1) pour transformer une tranche de semi-conducteur, le fil résistant chauffant (1) comprenant :
un corps (2) comprenant :
au moins une surface chauffante (4), l'au moins une surface chauffante (4) étant généralement lisse et généralement plate ;
un retrait (5) formé dans le corps (2) ; et
des première et seconde portions d'extrémité (7a, 7b), dans laquelle le retrait (5) n'est pas formé dans les première et seconde portions d'extrémité (7a, 7b),
**caractérisée en ce qu'**au moins une portion du corps (2) a une forme horizontalement symétrique en coupe transversale, dans laquelle horizontalement symétrique signifie symétrique par rapport à un plan parallèle à l'au moins une surface chauffante (4), et dans laquelle la forme en coupe transversale s'étend le long d'au moins une portion du corps (2), et
dans laquelle le retrait (5) est formé dans des portions à la fois de première et seconde surfaces du corps (2) formant une forme généralement en forme de I en coupe transversale, ou
dans laquelle le retrait (5) est formé dans des portions à la fois de première et seconde surfaces du corps (2) formant une forme généralement en forme de H en coupe transversale.

2. Utilisation selon la revendication 1, dans laquelle les première et seconde portions d'extrémité (7a, 7b) incluent un orifice de connexion de borne (3a, 3b).

3. Utilisation selon la revendication 1, dans laquelle le retrait (5) est formé dans des portions à la fois de première et seconde surfaces du corps (2) formant une forme généralement en forme de I en coupe transversale, et les première et seconde surfaces sont des surfaces supérieure et inférieure du corps (2), respectivement.

4. Utilisation selon la revendication 1, dans laquelle le retrait (5) est formé dans des portions à la fois de première et seconde surfaces du corps (2) formant une forme généralement en forme de H en coupe transversale, et les première et seconde surfaces sont des surfaces latérales opposées du corps (2).

5. Utilisation selon la revendication 1, dans laquelle les première et seconde portions d'extrémité (7a, 7b) ont une largeur essentiellement identique à une zone chauffante définie entre les première et seconde portions d'extrémité (7a, 7b), et ledit retrait (5) n'est pas formé au niveau des première et seconde portions d'extrémité (7a, 7b).

6. Utilisation selon la revendication 1, dans laquelle le corps (2) est enduit d'au moins un parmi pBN et SiC.

7. Utilisation selon la revendication 1, dans laquelle le corps (2) a une largeur essentiellement uniforme le long de sa longueur.

8. Utilisation selon l'une quelconque des revendications 1 à 7, comprenant les étapes consistant à :
(a) supporter une tranche de semi-conducteur sur l'au moins une surface chauffante (4) du fil résistant chauffant (1) ;
(b) appliquer un courant électrique au fil chauffant (1) ; et
(c) chauffer la tranche de semi-conducteur à une température prédéterminée.
